(19) Europäisches Patentamt
European Patent Office
Office européen des brevets

(11) **EP 2 342 249 B1**

(12) **EUROPÄISCHE PATENTSCHRIFT**

(45) Veröffentlichungstag und Bekanntmachung des Hinweises auf die Patenterteilung:
**25.10.2017 Patentblatt 2017/43**

(51) Int Cl.:
*G11B 7/24044* (2013.01)    *C08G 18/08* (2006.01)
*G03F 7/027* (2006.01)    *G03F 7/035* (2006.01)
*G03H 1/02* (2006.01)    *C08G 18/10* (2006.01)
*G11B 7/245* (2006.01)    *C08G 18/48* (2006.01)
*C08G 18/78* (2006.01)    *G11B 7/26* (2006.01)
*C08G 18/67* (2006.01)    *C08G 18/77* (2006.01)
*G03F 7/00* (2006.01)    *G11B 7/0065* (2006.01)
*G03H 1/26* (2006.01)

(21) Anmeldenummer: **09778689.1**

(22) Anmeldetag: **24.09.2009**

(86) Internationale Anmeldenummer:
**PCT/EP2009/006890**

(87) Internationale Veröffentlichungsnummer:
**WO 2010/037496 (08.04.2010 Gazette 2010/14)**

(54) **PREPOLYMERBASIERTE POLYURETHANFORMULIERUNGEN ZUR HERSTELLUNG HOLOGRAFISCHER MEDIEN**

PREPOLYMER-BASED POLYURETHANE FORMULATIONS FOR PRODUCING HOLOGRAPHIC MEDIA

FORMULES DE POLYURÉTHANE À BASE DE PRÉPOLYMÈRE POUR LA FABRICATION DE SUPPORTS HOLOGRAPHIQUES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.10.2008 EP 08017273**

(43) Veröffentlichungstag der Anmeldung:
**13.07.2011 Patentblatt 2011/28**

(73) Patentinhaber: **Covestro Deutschland AG**
**51373 Leverkusen (DE)**

(72) Erfinder:
• **WEISER, Marc-Stephan**
**51379 Leverkusen (DE)**
• **ROELLE, Thomas**
**51381 Leverkusen (DE)**
• **BRUDER, Friedrich-Karl**
**47802 Krefeld (DE)**
• **FÄCKE, Thomas**
**51375 Leverkusen (DE)**
• **HÖNEL, Dennis**
**53909 Zülpich (DE)**
• **DÖRR, Sebastian**
**40593 Düsseldorf (DE)**
• **STOECKEL, Nicolas**
**50733 Köln (DE)**

(74) Vertreter: **Levpat**
**c/o Covestro AG**
**Gebäude 4825**
**51365 Leverkusen (DE)**

(56) Entgegenhaltungen:
WO-A-03/023520    WO-A-03/102959
US-B2- 6 780 546

EP 2 342 249 B1

**EP 2 342 249 B1**

**Beschreibung**

Die vorliegende Erfindung betrifft neuartige Polyurethanzusammensetzungen, welche sich für die Herstellung holographischer Medien unter anderem für die Datenspeicherung, allerdings auch für optische Anwendungen verschiedenster Art in vorteilhafter Weise eignen.

Holographische Medien können unter anderem als Datenspeicher, auf dem Gebiet der Sicherheitstechnologie (beispielsweise der dreidimensionalen Darstellung von Personen oder Dingen sowie der Authentifizierung einer Person oder eines Gegenstandes), der Darstellung von Objekten, der Verwendung als Werbeträger, dem Einsatz als Hilfsmaterialien zur Herstellung komplexer dreidimensionaler Strukturen und als Bildschirm oder als Bauteile von Bildschirmteilen sowie zur Herstellung eines optischen Elements mit der Funktion einer Linse, eines Spiegels, eines Filters, einer Streuscheibe, eines Beugungselementes, eines Lichtleiters und/oder einer Maske eingesetzt werden.

Holographische Medien basierend auf einer Polymermatrix und einem oder mehreren darin eingebetteten radikalisch polymerisierbaren Verbindungen Schreibmonomeren sind beispielsweise in US 6,743,552 beschrieben.

Aus US 6743552, US 6765061 und US 6780546 sind Zweikomponenten-Polyurethanformulierungen bekannt, welche allerdings keine Prepolymere mit primären NCO-Gruppen aufweisen.

Aus US 6743552, US 6765061, US 6780546 und US 2006/0194120 sind Zweikomponenten-Polyurethanformulierungen bekannt. Die dort beschriebenen Formulierungen enthalten zum Teil Präpolymere als Isocyanat-Komponente, wobei es sich ausschließlich um solche Präpolymere mit sekundären Isocyanatgruppen handelt und daher in der Aushärtgeschwindigkeit unbefriedigend sind.

JP 2007101743 beschreibt den Einsatz von Präpolymeren bestehend aus Dicyclohexylmethan-4,4'-diisocyanate ("H12-MDI") und trifunktionellem Polypropylenoxid-glycerolether unter Zusatz von 1,4-Butandiol als Kettenverlängerer für die Herstellung von PU-Matrices für holografische Medien für die optische Datenspeicherung.

WO 03/102959 A offenbart holographische Datenspeichermedien, umfassend eine Aluminiumsalzverbindung und ein asymmetrische Acrylatverbindung.

WO 03/023520 A offenbart holographische Photopolymerdatenspeichermedien, ein Verfahren zur Herstellung und Verfahren zum holographischen Lesen, Aufnehmen und Speichern von Daten.

Nachteilig an den bekannten Systemen auf Polyurethanbasis ist jedoch insbesondere für optische Anwendungen außerhalb der digitalen Datenspeicherung, dass die erzielbare Helligkeit der in solchen Medien gespeicherten Hologramme zu niedrig ist. Grund hierfür ist meist, dass der relative Unterschied der Brechungsindices von Polyurethanmatrix und Schreibmonomer zu gering ist. Eine beliebige Variation des Matrixpolymers ist hingegen nicht möglich, da stets eine gute Verträglichkeit von Matrixpolymer mit Schreibmonomer und den weiteren in den Formulierungen enthaltenen Komponenten gewährleistet sein muss. Ferner ist aus verarbeitungstechnischen Gründen eine möglichst einfach durchzuführende Vermischung und Bereitstellung der Formulierungen von Interesse.

Aufgabe der vorliegenden Erfindung war es daher nun neue Polyurethanzusammensetzungen bereitzustellen, welche den oben genannten Anforderungen genügen.

Die Erfindung ist durch die angefügten Ansprüche definiert.

Es wurde nun überraschenderweise gefunden, dass sich die oben genannten Anforderungen erfüllen lassen, wenn anstatt monomerer oder oligomerer Isocyanate spezielle Prepolymere mit primär gebundenen NCO-Gruppen basierend auf difunktionellen Polyolen in der Isocyanatkomponente der Polyurethanzusammensetzungen eingesetzt werden.

Gegenstand der Erfindung sind daher Polyurethanzusammensetzungen, umfassend

A) eine Polyisocyanatkomponente, wenigstens enthaltend ein ausschließlich diolbasiertes, NCO-terminiertes Polyurethanprepolymer dessen NCO-Gruppen primär gebunden sind,

B) Isocyanat-reaktive Polymere

C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind.

D) Radikalstabilisatoren

E) Photoinitiatoren

F) Gegebenenfalls Katalysatoren

G) Gegebenenfalls Hilfs- und Zusatzstoffe,

dadurch gekennzeichnet, dass in A) als isocyanatfunktionelle Prepolymere Allophanate aus HDI oder TMDI und difunktionellen Polyetherpolyolen mit zahlenmittleren Molmassen von 1000 bis 8200 g/Mol eingesetzt werden.

Die erfindungswesentlichen Prepolymere der Komponente A) werden in dem Fachmann an sich gut bekannter Art und Weise durch Umsetzung von monomeren, oligomeren oder Polyisocyanaten A1) mit isocyanatreaktiven Verbindungen A2) in geeigneter Stöchiometrie unter optionalem Einsatz von Katalysatoren und Lösemitteln erhalten.

Auf diese Weise können NCO-funktionelle Prepolymere mit Urethan-, Allophanat-, Biuret- und/oder Amidgruppen hergestellt werden.

Als Polyisocyanate A1) zum Aufbau der Prepolymere werden HDI oder TMDI eingesetzt.

Auch offenbart ist, dass sich als Polyisocyanate A1) alle dem Fachmann an sich bekannten aliphatischen, cycloaliphatischen, aromatischen oder araliphatischen Di- und Triisocyanate eignen, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente A1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-oktan, Isocyanatomethyl-1,8-octandiisocyanat (TIN), 2,4- und/oder 2,6-Toluen-diisocyanat.

Als isocyanatreaktive Verbindungen A2) zum Aufbau der Prepolymere werden difunktionelle Polyetherpolyole mit zahlenmittleren Molmassen von 1000 bis 8200 g/Mol eingesetzt.

Auch offenbart ist das als isocyanatreaktive Verbindungen A2) zum Aufbau der Prepolymere bevorzugt OH- und/oder NH-funktionelle Verbindungen eingesetzt werden. Als oligomere oder polymere difunktionelle Isocyanat-reaktive Verbindungen zur Herstellung von Präpolymeren nach den oben genannten Verfahren eignen sich prinzipiell alle niedermolekulare kurzkettige, d.h. 2 bis 20 Kohlenstoffatome enthaltende aliphatische, araliphatische oder cycloaliphatische Diole und/oder höhere Polyole. Beispiele für Diole sind Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure(2,2-dimethyl-3-hydroxypropylester). Geeignet sind auch difunktionelle, höhermolekulare aliphatische und cycloaliphatische Polyole wie Polyesterpolyole, Polyetherpolyole, Polycarbonatpolyole, hydroxyfunktionelle Acrylharze, hydroxyfunktionelle Polyurethane, hydroxyfunktionelle Epoxyharze oder entsprechende Hybride (vgl. Römpp Lexikon Chemie, S.465-466, 10. Aufl. 1998, Georg-Thieme-Verlag, Stuttgart).

Als Polyesterpolyole kommen lineare Polyesterdiole in Betracht, wie sie in bekannter Weise aus aliphatischen, cycloaliphatischen oder aromatischen Di- bzw. Polycarbonsäuren bzw. ihren Anhydriden wie z. B. Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren Gemisch mit mehrwertigen Alkoholen wie z. B. Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxy-cyclohexan, 1,4-Dimethylolcyclohexan, Octandiol-1,8, Decandiol-1,10, Dodecandiol-1,12 oder deren Gemische hergestellt werden können. Als Alkohole zur Herstellung der Polyesterpolyole kommen natürlich auch cycloaliphatische und/oder aromatische Dihydroxylverbindungen in Frage. Anstelle der freien Polycarbonsäure können auch die entsprechenden Polycarbonsäureanhydride oder entsprechende Polycarbonsäureester von niedrigen Alkoholen oder deren Gemische zur Herstellung der Polyester verwendet werden.

Selbstverständlich kann es sich bei den Polyesterpolyolen auch um Homo- oder Mischpolymerisate von Lactonen handeln, die vorzugsweise durch Anlagerung von Lactonen bzw. Lactongemischen wie Butyrolacton, $\epsilon$-Caprolacton und/oder Methyl-$\epsilon$-caprolacton an geeignete di- und /oder höherfunktionelle Startermoleküle, wie z. B. die vorstehend als Aufbaukomponenten für Polyesterpolyole genannten niedermolekularen, mehrwertigen Alkohole, erhalten werden.

Auch Hydroxylgruppen aufweisenden Polycarbonate kommen als Polyhydroxylkomponenten in Betracht, z. B. solche, die durch Umsetzung von Diolen wie 1,4-Butandiol und/oder 1,6-Hexandiol und/oder 3-Methylpentandiol mit Diarylcarbonaten, z. B. Diphenylcarbonat, Dimethylcarbonat oder Phosgen hergestellt werden können.

Als Polyetherpolyole seien z. B. die difunktionellen Polyadditionsprodukte der Styroloxide, des Ethylenoxid, Propylenoxid, Tetrahydrofuran, Butylenoxid, Epichlorhydrins, sowie ihre Mischadditions- und Pfropfprodukte, sowie die durch Kondensation von zweiwertigen Alkoholen oder Mischungen derselben und die durch Alkoxylierung von zweiwertigen Alkoholen, Aminen und Aminoalkoholen gewonnenen Polyetherpolyole. Bevorzugte difunktionelle Polyetherpolyole sind Poly(propylenoxid)e, Poly(ethylenoxide) und deren Kombinationen in Form von statistischen oder Blockcopolymeren oder Poly(tetrahydrofuran)e sowie Mischungen derselben mit einer zahlenmittleren Molmasse zwischen 200 und 18000 g/Mol, besonders bevorzugt mit einer zahlenmittleren Molmasse zwischen 600 und 8000 g/Mol und ganz besonders bevorzugt mit einer zahlenmittleren Molmasse zwischen 650 und 4500 g/Mol.

Auch offenbart ist, dass der Einsatz von Aminen zur Prepolymerherstellung möglich ist. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Zur Urethanisierung wird Isocyanat mit Alkohol in stöchiometrischen Mengen umgesetzt, wobei eine Urethangruppe entsteht. Als Alkohole eignen sich in diesem Falle für die Umsetzung mit den erwähnten Di-, Tri- und Polyisocyanaten alle oligomeren oder polymeren, primären oder sekundären, difunktionellen Alkohole der vorstehend genannten Art. Im Rahmen der Urethanprepolymere sind dies bevorzugt Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Polyethylenglycol, Polypropylenglykol, Block- und/oder Copolymere aus Ethylenoxid und Propylenoxid, anderen 1-Alkenoxiden, Poly(THF), Polyester- und Polyacrylatpolyole mit zahlenmittleren Molmassen bis 10000 g/Mol oder deren beliebige Gemische untereinander.

Zur Allophanatisierung wird zunächst ein Isocyanat mit einem Alkohol in stöchiometrischem Verhältnis zu einem Urethan umgesetzt, welches anschließend mit einem weiteren Isocyanat umgesetzt wird, wobei ein Allophanat entsteht. Als Alkohol eignen sich in diesem Falle für die Umsetzung mit den erwähnten Di-, Tri- oder Polyisocyanaten zum Urethan alle oligomeren oder polymeren, primären oder sekundären, difunktionellen Alkohole der vorstehend beschriebenen Art. Für die weitere Umsetzung zum Allophanat werden bevorzugt die monomeren Di- oder Triisocyanate HDI, TMDI und TIN zugesetzt. Bevorzugte isocyanatreaktive Verbindungen zum Allophanataufbau sind Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, 1,6-Hexandiol sowie höhere Polyole vom Typ der aliphatischen Polyesterpolyole, Polyetherpolyole, Polycarbonatpolyole.

Offenbarte Präpolymere sind Urethane, Allophanate oder Biurete aus aliphatischen Isocyanatfunktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol. Erfindungsgemäß sind die als Komponente A eingesetzten isocyanatfunktionellen Prepolymere Allophanate aus HDI oder TMDI und difunktionellen Polyetherpolyolen mit zahlenmittleren Molmassen von 1000 bis 8200 g/Mol.

Bevorzugt weisen die vorstehend beschriebenen Präpolymere Restgehalte an freiem monomeren Isocyanat von weniger als 1 Gew.-%, besonders bevorzugt weniger als 0,5 Gew.-%, ganz besonders bevorzugt weniger als 0,2 Gew.-% auf.

Selbstverständlich kann die Isocyanatkomponente anteilsmäßig neben den beschriebenen Präpolymeren weitere Isocyanatkomponenten enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente A) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigten Verbindungen α,β-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxidmono(meth)acrylate, Polyalkylenoxidmono(meth)acrylate, Poly(ε-caprolacton)-mono(meth)acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten die teilweise mit isocyanatreaktiven ethylenisch ungesättigten Verbindungen umgesetzt sind an der Isocyanatkomponente A beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente A) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Als Komponente B) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 8000 g/Mol, besonders bevorzugt von 500 bis 4000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2400 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.0.

Daneben sind als Bestandteile der Komponente B) als polyfunktionelle, isocyanatreaktive Verbindungen auch niedermolekulare, d.h. mit Molekulargewichten kleiner 500 g/Mol, kurzkettige, d.h. 2 bis 20 Kohlenstoffatome enthaltende aliphatische, araliphatische oder cycloaliphatische di-, tri- oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure(2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Bevorzugte Komponenten B) sind Polyetherpolyole sind Poly(propylenoxid)e, Poly(ethylenoxide) und deren Kombinationen in Form von statistischen oder Blockcopolymeren sowie Blockcopolymere aus Propylenoxid und/oder Ethylenoxid, die zusätzlich Tetrahydrofuran, Butylenoxid oder ε-Caprolacton als Monomereinheiten enthalten sowie Mischungen derselben mit einer OH-Funktionalität von 1,5 bis 6 und einer zahlenmittleren Molmasse von 200 bis 18000 g/Mol, besonders bevorzugt mit einer OH-Funktionalität von 1,8 bis 4,0 und einer zahlenmittleren Molmasse von 600 bis 8000 g/Mol und ganz besonders bevorzugt mit einer OH-Funktionalität von 1,9 bis 3,1 und einer zahlenmittleren Molmasse von 650 bis 4500 g/Mol.

Bevorzugte in C) einzusetzende Verbindungen weisen Brechungsindices von größer 1,55, besonders bevorzugt 1,58 eingesetzt.

In Komponente C) können Verbindungen wie $\alpha,\beta$-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, $\alpha$-Methylstyrol, Vinyl-toluol, Olefinine, wie z.B. 1-Octen und/oder 1-Decen, Vinylestern, (Meth)acrylnitril, (Meth)acrylamid, Methacrylsäure, Acrylsäure eingesetzt werden. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenylmethacrylat, 2,4,6-Trichlorphenylacrylat, 2,4,6-Trichlorphenylmethacrylat, 2,4,6-Tribromphenylacrylat, 2,4,6-Tribromphenylmethacrylat, Pentachlorphe-nylacrylat, Pentachlorphenylmethacrylat, Pentabromphenylacrylat, Pentabromphenylmethacrylat, Pentabrombenzyl-acrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl verwendbarer Acrylate und Methacrylate zu nennen.

Selbstverständlich können auch Urethanacrylate als Komponente C) verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanatfunktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly($\varepsilon$-caprolacton)mono(meth)acrylate. Darüberhinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden (Meth-)Acrylate und/oder Urethan(meth-)acrylate verwendet, besonders bevorzugt (Meth-)Acrylate und/oder Urethan(meth-)acrylate die mindestens eine aromatische Struktureinheit aufweisen.

Besonders bevorzugte als Komponente C) zu verwendende Verbindungen sind Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxid-mono(meth)acrylat, Polyalkylenoxidmono(meth)acrylat und Poly($\varepsilon$-caprolacton)mono(meth)-acrylate.

In einer ganz besonders bevorzugten Ausführungsform werden als Komponente C) die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat eingesetzt. In einer weiteren ganz besonders bevorzugten Ausführungsform werden als Komponente C Additionsprodukte von 3-Thiomethyl-phenylisocyanat mit Hydroxyethylacrylat, Hydroxypropylacrylat, 4-Hydroxybutylacrylat eingesetzt

Beispiele für Vinylaromaten sind Styrol, halogenierte Derivate von Styrol wie z.B. 2-Chlorstyrol, 3-Chlorstyrol, 4-Chlorstyrol, 2-Bromstyrol, 3-Bromstyrol, 4-Bromstyrol, p-(Chlormethyl)styrol, p-(Brommethyl)styrol oder 1-Vinylnaphthalin, 2-Vinylnaphthalin, 2-Vinylantracen, 9-Vinylanthracen, 9-Vinylcarbazol oder difunktionelle Verbindungen wie Divinylbenzol.

Als Verbindungen der Komponente D) geeignet sind beispielsweise Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-*tert*.-Butylchinon, ggf. auch aromatische Amine wie Diisopropylamin oder Phenothiazin.

Bevorzugt sind 2,6-Di-*tert*.-butyl-4-methylphenol, Phenothiazin, p-Methyoxyphenol, 2-Methoxy-p-hydrochinon und Benzhydrol.

Als Komponente E) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxid, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) bekannt. Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalkation, welches sich durch H-Abstraktion stabilisiert, ein Proton freisetzt und dann die kationische Polymerisation startet (Dektar et al. J. Org. Chem. 1990, 55, 639; J. Org. Chem., 1991, 56, 1838). Dieser Mechanismus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls die recht teuren $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivaten (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Die vorgenannte Einstellung hinsichtlich der Photopolymerisation ist für einen Fachmann in Form von Routineversuchen innerhalb der unten angegebenen Mengenbereiche der Komponenten sowie der jeweils zur Auswahl stehenden, insbesondere den bevorzugten Aufbaukomponenten, leicht möglich.

Bevorzugte Photoinitiatoren E) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Als Verbindungen der Komponente F) können gegebenenfalls ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis(ethyl-hexanoat), Zirconium-acteylacetonat oder tertiäre Aminen wie beispielsweise 1,4-Diazabi-cyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Selbstverständlich können gegebenenfalls weitere Zusatzstoffe G) eingesetzt werden. Dabei kann es sich beispielsweise um im Bereich der Lacktechnologie gängige Zusatzstoffe wie Lösemittel, Weichmacher, Verlaufsmittel oder Haftvermittler handeln. Als Weichmacher werden dabei bevorzugt Flüssigkeiten mit guten Löseeigenschaften, geringer Flüchtigkeit und hoher Siedetemperatur eingesetzt. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Typische Polyurethanzusammensetzungen umfassen:

1 bis 60 Gew.-% der erfindungswesentlichen Komponenten A),
5 bis 93.999 Gew.-% Komponente B)
5 bis 70 Gew.-% der Komponente C)
0.001 bis 10 Gew.-% Photoinitiatoren E),
0 bis 10 Gew.-% Radikalstabilisatoren D)
0 bis 4 Gew.-% Katalysatoren F)
0 bis 70 Gew.-% Hilfs- und Zusatzstoffe G)

Bevorzugt umfassen die erfindungsgemäßen Polyurethanzusammensetzungen
10 bis 55 Gew.-% der erfindungswesentlichen Komponenten A),
15 bis 79,989 Gew.-% Komponente B)
10 bis 70 Gew.-% der Komponente C)
0.01 bis 7.5 Gew.-% Photoinitiatoren E),
0.001 bis 2 Gew.-% Radikalstabilisatoren D)
0 bis 3 Gew.-% Katalysatoren F)
0 bis 50 Gew.-% Hilfs- und Zusatzstoffe G)

Besonders bevorzugt umfassen die erfindungsgemäßen Polyurethanzusammensetzungen
15 bis 50 Gew.-% der erfindungswesentlichen Komponenten A),
25 bis 69,489 Gew.-% Komponente B)
15 bis 50 Gew.-% der Komponente C)
0.5 bis 5 Gew.-% Photoinitiatoren E),
0.01 bis 0,5 Gew.-% Radikalstabilisatoren D)
0.001 bis 2 Gew.-% Katalysatoren F)
0 bis 35 Gew.-% Hilfs- und Zusatzstoffe G)

Ein weiterer Gegenstand der vorliegenden Erfindung ist daher auch ein Verfahren zur Herstellung von Medien zur Aufzeichnung visueller Hologramme, bei dem solche Photopolymerformulierung en auf ein Substrat oder in eine Form appliziert und ausgehärtet werden. Ebenfalls ein Gegenstand der Erfindung sind die so erhältlichen Medien.

Das erfindungsgemäße Verfahren wird bevorzugt derart durchgeführt, dass die Aufbaukomponenten der erfindungsgemäßen Polyurethanzusammensetzungen mit Ausnahme der Komponente A) miteinander homogen vermischt werden und unmittelbar vor der Applikation auf das Substrat oder in die Form erst Komponente A) zugemischt wird.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente A) ist bevorzugt, um Blasenbildung durch Restgase in den erhältlichen Medien zu verhindern.

Vor Zumischung der Komponente A) können die Mischungen als lagerstabiles Zwischenprodukt gegebenenfalls über mehrere Monate gelagert werden kann.

Nach der Zumischung der Komponente A) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die in einer Menge von 15 g und mit einem Katalysatorgehalt von 0,004 Gew.-% bei 25°C unter 4 Stunden aushärten, bzw. bei einem Katalysatorgehalt von 0,02 % in weniger als 10 Minuten bei 25°C aushärten.

Zur Applikation auf ein Substrat bzw. in eine Form sind alle jeweiligen gängigen, dem Fachmann bekannten Verfahren geeignet, wie insbesondere Rakeln, Gießen, Drucken, Siebdruck, Spritzen, oder Inkjet-Druck.

Ein weiterer Gegenstand der vorliegenden Erfindung ist daher die Verwendung der erfindungsgemäßen Medien zur Aufzeichnung visueller Hologramme, zur Herstellung von optischen Elementen, Bildern, Darstellungen sowie ein Verfahren zur Aufzeichnung von Hologrammen unter Verwendung der erfindungsgemäßen Polyurethanzusammensetzungen und den daraus zugänglichen Medien oder holografischen Filmen.

Mit den erfindungsgemäßen Polyurethanzusammensetzungen können durch entsprechende Belichtungsprozesse Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken haben. Häufig zeigen diese optischen Elemente eine Frequenzselektivität je nachdem wie die Hologramme belichtet wurden und welche Dimensionen das Holgramm hat.

Zudem können mittels der erfindungsgemäßen Polyurethanzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

**Beispiele:**

Die folgenden Beispiele sind zur Erläuterung der erfindungsgemäßen Photopolymere genannt, sollen aber nicht als begrenzend verstanden sein. Sofern nicht abweichend vermerkt beziehen sich alle Prozentangaben auf Gewichtsprozent.

Desmodur® XP 2410 ist ein Versuchsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %

Desmodur® XP 2599 ist ein Versuchsprodukt der Bayer MaterialScience AG, Leverkusen, DE, Vollallophanat von Hexandiisocyanat auf Acclaim 4200, NCO-Gehalt: 5,6 - 6,4 %

Präpolymer 1 ist ein experimentelles Produkt der Bayer MaterialScience AG, Leverkusen, DE, Vollallophanat von Hexandiisocyanat auf Acclaim 4200, NCO-Gehalt: 3,1 %

Präpolymer 2 ist ein experimentelles Produkt der Bayer MaterialScience AG, Leverkusen, DE, Vollallophanat von TMDI auf Acclaim 2200, NCO-Gehalt: 4,35 %

Präpolymer 3 ist ein experimentelles Produkt der Bayer MaterialScience AG, Leverkusen, DE, Vollallophanat von Hexandiisocyanat und Acclaim 8200, NCO-Gehalt: 1,88 - 1.92 %

Präpolymer 4 ist ein experimentelles Produkt der Bayer MaterialScience AG, Leverkusen, DE, Urethan von Hexandiisocyanat und Acclaim 2200, NCO-Gehalt: 3,2 - 3,75 %

Polyol 1 ist ein experimentelles Produkt der Bayer MaterialScience AG, Leverkusen, DE, Blockcopolymer von Terathane® 1000 und $\varepsilon$-Caprolacton.

Polyol 2 ist ein difunktionelles Poly($\varepsilon$-Caprolacton)-polyols (zahlenmittlere Molmasse ca. 650 g/Mol).

Urethanacrylat 1 ist ein experimentelles Produkt der Bayer MaterialScience AG, Leverkusen, DE, Urethanacrylat auf Basis von HEA und Desmodur® RFE.

Fomrez® UL28: Urethanisierungskatalysator, Dimethylbis[(1-oxoneodecl)oxy]stannan, Handelsprodukt der Fa. Momentive Performance Chemicals, Wilton, CT, USA (als 10%ige Lösung in N-Ethylpyrrolidon eingesetzt).

CGI 909 ist ein im Jahr 2008 von der Fa. Ciba Inc., Basel, Schweiz vertriebenes Versuchsprodukt.

Messung von Beugungswirkungsgrad DE und Brechungsindexkontrast $\Delta$n:

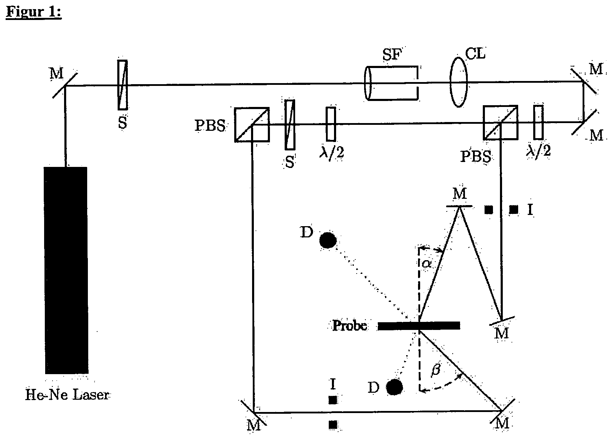

Die im Rahmen des experimentellen Teils hergestellten erfindungsgemäßen und Vergleichsmedien wurden mittels einer Messanordnung gemäß Figur 1 auf ihre holographischen Eigenschaften geprüft:

Figur 1: Geometrie eines Holographic Media Testers bei λ = 633 nm (He-Ne Laser)zum Schreiben eines Reflexionshologrammes: M = Spiegel, S = Verschluss, SF = Raumfilter, CL = Kollimatorlinse, λ/2 = λ/2 Platte, PBS = polarisationsempfindlicher Strahlteiler, D = Detektor, I = Irisblende, α = 21.8° und β = 41.8° sind die Einfallswinkel der kohärenten Strahlen ausserhalb der Probe (des Mediums) gemessen.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die λ/2 Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahls beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ~ 225 nm (Brechungsindex des Mediums zu ~1.49 angenommen).

Es wurden auf folgende Weise Hologramme in das Medium geschrieben:

Beide Shutter (S) sind für die Belichtungszeit t geöffnet. Danach wurde bei geschlossenen Shuttern (S) dem Medium 5 Minuten Zeit für die Diffusion der noch nicht polymerisierten Schreibmonomere gelassen. Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel □□wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz η ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω□ des geschriebenen Hologramms gemessen und in einem Computer gespeichert. Zusätzlich wurde auch die in die nullte Ordnung transmittierte Intensität gegen der Drehwinkel Ω aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast Δn und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve η/(Ω) eines Reflexionshologramms gilt nach Kogelnik:

$$\eta = \frac{1}{1 + \dfrac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha'-\psi)}{\Lambda \cdot \cos(\alpha'-2\psi)} \cdot \frac{d}{2}$$

$$\psi = \frac{\beta'-\alpha'}{2}$$

$$\Lambda = \frac{\lambda}{2 \cdot n \cdot \cos(\psi - \alpha')}$$

$$n \cdot \sin(\alpha') = \sin(\alpha), \, n \cdot \sin(\beta') = \sin(\beta)$$

$$\Delta\theta = -\Delta\Omega \cdot \sqrt{\frac{1-\sin^2(\alpha)}{n^2-\sin^2(\alpha)}}$$

$\Phi$ ist die Gitterstärke, $\chi$ ist der Detuning Parameter und $\Psi$ der Kippwinkel des Brechungsindexgitters, das geschrieben wurde. $\alpha'$ und $\beta'$ entsprechen den Winkeln $\alpha$ und $\beta$ beim Schreiben des Hologramms, aber im Medium. $\Delta\Theta$ ist das Winkeldetuning gemessen im Medium, also die Abweichung vom Winkel $\alpha'$. $\Delta\Omega$ ist das Winkeldetuning gemessen außerhalb des Mediums, also die Abweichung vom Winkel $\alpha$. n ist der mittlere Brechungsindex des Photopolymers und wurde zu 1.504 gesetzt.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha'-2\psi)}}\right)$$

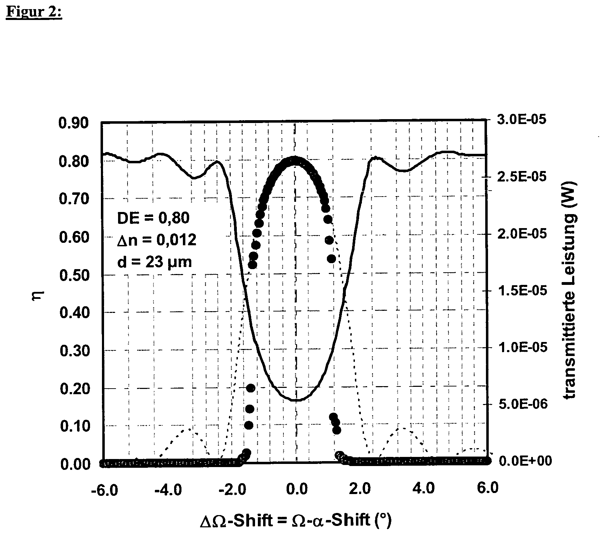

Die Messdaten der Beugungseffizienz, die theoretische Braggkurve und die transmittierte Intensität werden wie in Figure 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta n$ wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Holgrammen (kleines d) bei einem $\Omega$-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2: Darstellung der Braggkurve $\eta$ nach Kogelnik (gestrichelte Linie), des gemessenen Beugungswirkungsgrades (ausgefüllte Kreise) und der transmittierten Leistung (schwarz durchgezogene Linie) gegen das Winkeldetuning $\Delta\Omega$. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E\,(\mathrm{mJ/cm}^2) = \frac{2 \cdot \big[0.50\,\mathrm{mW} + 0.67\,\mathrm{mW}\big] \cdot t\,(\mathrm{s})}{\pi \cdot 0.4^2\,\mathrm{cm}^2}$$

Die Leistungen der Teilstrahlen wurden so angepasst, dass in dem Medium bei den verwendeten Winkeln $\alpha$ und $\beta$, die gleiche Leistungsdichte erreicht wird.

Herstellung von Polyol 1:

In einem 1 L Kolben wurden 0.18 g Zinnoktoat, 374.8 g $\varepsilon$-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

Herstellung des Urethanacrylates 1:

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Herstellung des Präpolymers 1:

In einem Rundkolben wurden 378,0 g Hexamethylendiisocyanat (HDI) unter Rühren und Durchperlen von N2 vorgelegt und 0,019 g Isophthalsäuredichlorid zugegeben. Die Mischung wurde auf 100 °C erwärmt und über 3 Stunden 576,36 g Acclaim 4200 (Polypropylenoxid der zahlenmittleren Molmasse 4000 g/Mol) zugegeben. Es wurde so lange gerührt, bis ein NCO-Wert von 18,5 % NCO erreicht wurde, dann wurde auf 90 °C abgekühlt und 0,076 g Zink-bis-2-ethylhexanoat zugegeben. Es wurde so lange gerührt, bis der theoretische Ziel-NCO-Wert erreicht wurde (17,2 % NCO). Die Reaktion wird dann durch Abkühlen auf Raumtemperatur und Zugabe von 0,095 g Isophthalsäuredichlorid gestoppt. Dann wird das überschüssige HDI durch Destillation über einen Dünnschichtverdampfer bei 140°C abgetrennt (Rest HDI < 0.03%). Das Produkt wird als gelbliche Flüssigkeit erhalten.

Herstellung des Präpolymers 2:

In einem Rundkolben wurden 236,25 g 2,2,4-Trimethyl-hexamethylendiisocyanat (TMDI) unter Rühren und Durchperlen von N2 vorgelegt und 0,008 g Isophthalsäuredichlorid zugegeben. Die Mischung wurde auf 100 °C erwärmt und über 3 Stunden 167,67 g Acclaim 2200 (Polypropylenoxid der zahlenmittleren Molmasse 2000 g/Mol) zugegeben. Es wurde so lange gerührt, bis ein NCO-Wert von 21,8 % NCO erreicht wurde, dann wurde auf 90 °C abgekühlt und 0,077 g Zink-bis-2-ethylhexanoat zugegeben. Es wurde so lange gerührt, bis der theoretische Ziel-NCO-Wert erreicht wurde (20,3 % NCO). Dann wurde die Reaktion durch Abkühlen auf Raumtemperatur gestoppt. Dann wird das überschüssige HDI durch Destillation über einen Dünnschichtverdampfer bei 140 °C abgetrennt (Rest TMDI <0.12%). Das Produkt wird als farblose Flüssigkeit erhalten.

Herstellung des Präpolymers 3:

400 g HDI (Hexamethylendiisocyanat) und 0,06 g Zirkooktoat werden in einem 41 Vierhalskolben unter Rühren bei 110°C vorgelegt. Innerhalb von 1,5 Stunden fügt man 1570 g difunktionelles Polypropylenglykol der zahlenmittleren Molmasse 8000 g/Mol so hinzu, dass eine Temperatur von 115°C gehalten wird. Nach 2 weiteren Stunden bei gleicher Temperatur wird 0,06 g Dibutylphosphat zugesetzt und anschließend auf 75°C abgekühlt. Bei dieser Temperatur wird die Mischung filtriert. Dann setzt man 700 g HDI (Hexamethylendiisocyanat) und 0,5 g Benzoylchlorid hinzu. Anschließend wurde durch Dünnschichtdestillation bei 130°C und 0,1 Torr das überschüssige HDI abdestilliert. Das erhaltene Prepolymer hat einen NCO-Gehalt von 1,92% und eine Viskosität von ca. 8000 mPas (25°C).

Herstellung des Präpolymers 4:

1300 g HDI (Hexamethylendiisocyanat), 1,3 g Benzoylchlorid und 1,3 g *para*-Toluonsulfonsäuremethylester werden in einem 4 l Vierhalskolben unter Rühren vorgelegt. Innerhalb von 3 Stunden fügt man bei 80°C 1456 g eines difunktionellen Polypropylenglykol-Polyethers mit einem zahlenmittleren Molekulargewicht von 2000 g/Mol hinzu und rührte 1 Stunde bei gleicher Temperatur nach. Anschließend wurde durch Dünnschichtdestillation bei 130°C und 0,1 Torr das überschüssige HDI abdestilliert. Das erhaltene Prepolymer hat einen NCO-Gehalt von 3,23% und eine Viskosität von 1650 mPas (25°C).

Zur Herstellung der holografischen Medien werden die Komponente C, die Komponente D (die bereits in der Komponente C vorgelöst sein kann) sowie gegebenenfalls die Komponente G in der Komponente B gegebenenfalls bei 60 °C gelöst, dann werden Glasperlen der Größe 20 $\mu$m (z. B. der Fa. Whitehouse Scientific Ltd, Waverton, Chester, CH3 7PB, United Kingdom) zugegeben und gründlich gemischt. Danach wird im Dunkeln oder unter geeigneter Beleuchtung die Komponente E in reiner Form oder in verdünnter Lösung in NEP zugewogen und im erneut 1 Minute gemischt. Gegebenenfalls wird maximal 10 Minuten im Trockenschrank auf 60 °C erhitzt. Dann wird Komponente A zugegeben und wieder im 1 Minute gemischt. Im Folgenden wird eine Lösung der Komponente F zugegeben und im erneut 1 Minute gemischt. Die erhaltene Mischung wird unter Rühren bei < 1 mbar maximal 30 Sekunden entgast, dann wird sie auf Glasplatten von 50 x 75 mm verteilt und diese je mit einer weiteren Glasplatte abgedeckt. Die Härtung der PU-Formulierung erfolgt unter 15 kg Gewichten über mehrere Stunden (gewöhnlich über Nacht). Teilweise werden die Medien in lichtdichter Verpackung noch 2 Stunden bei 60 °C nachgehärtet. Die Dicke d der Photopolymerschicht ergibt sich aus dem Durchmesser der verwendeten Glaskugeln zu 20 $\mu$m. Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führen, wird d anhand der Charakteristika der geschriebenen Hologramme für jede Probe separat ermittelt.

### Vergleichsbeispiel 1 (Medium):

8.89 g der wie oben beschrieben hergestellten Polyol 1 (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 1.647 g Desmodur® XP 2410 (Vergleich für Komponente A) zugegeben und erneut gemischt. Schließlich wurden 0.009 g Fomrez UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0,0101.

### Vergleichsbeispiel 2 (Medium):

6.117 g des Polyols 2 (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 4.418 g Baytec® WE 180 (Vergleich für Komponente A) zugegeben und erneut gemischt. Schließlich wurden 0.030 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0063.

### Beispiel 1 (Medium):

7.743 g Acclaim® 4200 (Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.792 g Desmodur® XP 2599 (Komponente A) zugegeben und erneut gemischt. Schließlich wurden 0.0245 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 $\mu$m gehalten wurde. Dieser Probenkörper wurde bei Raumtemperatur liegen gelassen und über 16 Stunden gehärtet. Maximaler $\Delta$n: 0.0158.

### Beispiel 2 (Medium):

5.63 g Polyether L 5050 (difunktioneller Mischpolyether aus Ethylen- und Propylenoxid mit gesamt 50 % Ethylenoxidanteil des Equivalentgewichts 984,2 g/Mol) (Komponente B) wurden mit 4.50 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 4.154 g Desmodur® XP 2599 (Komponente A) zugegeben und erneut gemischt. Schließlich wurden 0.0323 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0142.

**Beispiel 3 (Medium):**

7.554 g Acclaim® 4220 N (ethylenoxid-gecapptes Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 2.983 g Desmodur® XP 2599 (Komponente A) zugegeben und erneut gemischt. Schließlich wurden 0.0071 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0141.

**Beispiel 4 (Medium):**

6.128 g Acclaim® 4200 (Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 4.408 g Präpolymer 1 (Komponente A) zugegeben und erneut gemischt. Schließlich wurden 0.0150 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0147.

**Beispiel 5 (Medium):**

6.965 g Acclaim® 4200 (Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 3.570 g Präpolymer 2 (Komponente A) zugegeben und erneut gemischt. Schließlich wurden 0.0293 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0150.

**Beispiel 6 (Medium):**

4,819 g Acclaim® 4200 (Polypropylenoxid der zahlenmittleren Molmasse 4000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, 5,716 g Präpolymer 3 (Komponente A) zugegeben und erneut gemischt. Schließlich wurden 0.0252 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler Δn: 0.0211.

**Beispiel 7 (Medium):**

5.497 g Acclaim® 2200 (Polypropylenoxid der zahlenmittleren Molmasse 2000 g/Mol) (Komponente B) wurden mit 3.75 g Urethanacrylat 1 (Komponente C), 0.15 g CGI 909 und 0.015 g Neu Methylenblau (zusammen Komponente E) bei 60 °C und 0.525 g N-Ethylpyrilidon (Komponente G) gemischt, so dass eine klare Lösung erhalten wurde. Anschließend wurde auf 30 °C abgekühlt, eine Mischung aus 1,783 g Desmodur® XP 2599 und 3,254 g Präpolymer 4 (zusammen Komponente A) zugegeben und erneut gemischt. Schließlich wurden 0.030 g Fomrez® UL 28 (Komponente F) zugegeben und erneut kurz gemischt. Die erhaltene, flüssige Masse wurde dann auf eine Glasplatte gegeben und dort mit einer zweiten Glasplatte abgedeckt, die durch Abstandshalter auf einen Abstand von 20 μm gehalten wurde. Dieser Probenkörper wurde bei Raumtemperatur liegen gelassen und über 16 Stunden gehärtet. Maximaler $\Delta$n: 0.0168.

**Patentansprüche**

1. Polyurethanzusammensetzungen, umfassend

   A) eine Polyisocyanatkomponente, wenigstens enthaltend ein ausschließlich diolbasiertes, NCO-terminiertes Polyurethanprepolymer dessen NCO-Gruppen primär gebunden sind,
   B) Isocyanat-reaktive Polymere,
   C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind,
   D) Radikalstabilisatoren,
   E) Photoinitiatoren,
   F) gegebenenfalls Katalysatoren,
   G) gegebenenfalls Hilfs- und Zusatzstoffe,

   **dadurch gekennzeichnet, dass** in A) als isocyanatfunktionelle Prepolymere Allophanate aus HDI oder TMDI und difunktionellen Polyetherpolyolen mit zahlenmittleren Molmassen von 1000 bis 8200 g/Mol eingesetzt werden.

2. Polyurethanzusammensetzungen gemäß Anspruch 1 , **dadurch gekennzeichnet, dass** die in A) als isocyanatfunktionelle Prepolymere eingesetzten Verbindungen Restgehalte an freiem monomerem Isocyanat von weniger als 0,5 Gew.-% aufweisen.

3. Polyurethanzusammensetzungen gemäß einem der Ansprüche 1 bis 2, **dadurch gekennzeichnet, dass** in Komponente B) Homopolymere oder statistische oder Blockcopolymere basierend auf Ethylenoxid und/oder Propylenoxid gegebenenfalls in Kombination mit Tetrahydrofuran, Butylenoxid oder ε-Caprolacton als Monomereinheiten eingesetzt werden, mit einer OH-Funktionalität von 1,5 bis 6 und einer zahlenmittleren Molmasse von 200 bis 18000 g/Mol.

4. Polyurethanzusammensetzungen gemäß einem der Ansprüche 1 bis 3, **dadurch gekennzeichnet, dass** die in Komponente C) eingesetzten Verbindungen einen Brechungsindex $n_D^{20}$ > 1,55 aufweisen.

5. Polyurethanzusammensetzungen gemäß einem der Ansprüche 1 bis 4, **dadurch gekennzeichnet, dass** in Komponente C) Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxidmono-(meth)acrylat, Polyalkylenoxidmono-(meth)acrylat und Poly(ε-caprolacton)mono(meth)acrylate eingesetzt werden.

6. Verfahren zur Herstellung von Medien zur Aufzeichnung visueller Hologramme, bei dem Polyurethanzusammensetzungen gemäß einem der Ansprüche 1 bis 5 auf ein Substrat oder in eine Form appliziert und ausgehärtet werden.

7. Medien zur Aufzeichnung visueller Hologramme erhältlich nach einem Verfahren gemäß Anspruch 6.

8. Verwendung von Medien gemäß Anspruch 7 als optische Elemente, Bilder oder zur Bilddarstellung oder -projektion.

9. Verfahren zur Aufzeichnung eines Hologramms, bei dem Medien gemäß Anspruch 7 eingesetzt werden.

**Claims**

1. Polyurethane compositions comprising

   A) a polyisocyanate component at least containing an exclusively diol-based NCO-terminated polyurethane prepolymer, the NCO groups of which are bonded in a primary manner,

B) isocyanate-reactive polymers,
C) compounds which have groups which react by polymerizing with ethylenically unsaturated compounds under the action of actinic radiation (radiation-curing groups) and are themselves free of NCO groups,
D) free-radical stabilizers,
E) photoinitiators,
F) optionally catalysts,
G) optionally assistants and additives,

**characterized in that** the isocyanate-functional prepolymers used in A) are allophanates formed from HDI or TMDI and difunctional polyether polyols having number-average molar masses of 1000 to 8200 g/mol.

2. Polyurethane compositions according to Claim 1, **characterized in that** the compounds used as isocyanate-functional prepolymers in A) have residual contents of free monomeric isocyanate of less than 0.5% by weight.

3. Polyurethane compositions according to either of Claims 1 and 2, **characterized in that** homopolymers or random or block copolymers based on ethylene oxide and/or propylene oxide, optionally in combination with tetrahydrofuran, butylene oxide or $\varepsilon$-caprolactone as monomer units, are used in component B), with an OH functionality of 1.5 to 6 and a number-average molar mass of 200 to 18 000 g/mol.

4. Polyurethane compositions according to any of Claims 1 to 3, **characterized in that** the compounds used in component C) have a refractive index $n_D^{20}$ of > 1.55.

5. Polyurethane compositions according to any of Claims 1 to 4, **characterized in that** urethane acrylates and urethane methacrylates based on aromatic isocyanates and 2-hydroxyethyl acrylate, hydroxypropyl acrylate, 4-hydroxybutyl acrylate, polyethylene oxide mono(meth)acrylate, polypropylene oxide mono(meth)acrylate, polyalkylene oxide mono(meth)acrylate and poly($\varepsilon$-caprolactone) mono(meth)acrylates are used in component C).

6. Process for producing media for recording visual holograms, in which polyurethane compositions according to any of Claims 1 to 5 are applied to a substrate or to a mold and cured.

7. Media for recording visual holograms obtainable by a process according to Claim 6.

8. Use of media according to Claim 7 as optical elements, images or for imaging or image projection.

9. Process for recording a hologram, in which media according to Claim 7 are used.

**Revendications**

1. Compositions de polyuréthane, comprenant :

A) un composant polyisocyanate, contenant au moins un prépolymère de polyuréthane à terminaison NCO, exclusivement à base de diols, dont les groupes NCO sont reliés primairement,
B) des polymères réactifs avec les isocyanates,
C) des composés qui comprennent des groupes réactifs sous l'effet d'un rayonnement actinique avec des composés éthyléniquement insaturés avec polymérisation (groupes durcissables par rayonnement) et sont eux-mêmes exempts de groupes NCO,
D) des stabilisateurs de radicaux,
E) des photoinitiateurs,
F) éventuellement des catalyseurs,
G) éventuellement des adjuvants et additifs,

**caractérisées en ce qu'**en A), des allophanates à base d'HDI ou de TMDI et de polyéther-polyols difonctionnels ayant des masses molaires moyennes en nombre de 1 000 à 8 200 g/mol sont utilisés en tant que prépolymères à fonction isocyanate.

2. Compositions de polyuréthane selon la revendication 1, **caractérisées en ce que** les composés utilisés en A) en tant que prépolymères à fonction isocyanate présentent des teneurs résiduelles en isocyanate monomère libre de moins de 0,5 % en poids.

3. Compositions de polyuréthane selon l'une quelconque des revendications 1 à 2, **caractérisées en ce que**, dans le composant B), des homopolymères ou des copolymères statistiques ou séquencés à base d'oxyde d'éthylène et/ou d'oxyde de propylène, éventuellement en combinaison avec du tétrahydrofurane, de l'oxyde de butylène ou de l'ε-caprolactone, sont utilisés en tant qu'unités monomères, ayant une fonctionnalité OH de 1,5 à 6 et une masse molaire moyenne en nombre de 200 à 18 000 g/mol.

4. Compositions de polyuréthane selon l'une quelconque des revendications 1 à 3, **caractérisées en ce que** les composés utilisés dans le composant C) présentent un indice de réfraction $n_D^{20} > 1,55$.

5. Compositions de polyuréthane selon l'une quelconque des revendications 1 à 4, **caractérisées en ce que**, dans le composant C), des acrylates d'uréthane et des méthacrylates d'uréthane à base d'isocyanates aromatiques et d'acrylate de 2-hydroxyéthyle, d'acrylate d'hydroxypropyle, d'acrylate de 4-hydroxybutyle, de mono(méth)acrylate d'oxyde de polyéthylène, de mono(méth)acrylate d'oxyde de polypropylène, de mono(méth)acrylate d'oxyde de polyalkylène et de mono(méth)acrylates de polo (ε-caprolactone) sont utilisés.

6. Procédé de fabrication de supports pour l'enregistrement d'hologrammes visuels, selon lequel des compositions de polyuréthane selon l'une quelconque des revendications 1 à 5 sont appliquées sur un substrat ou dans un moule et durcies.

7. Supports pour l'enregistrement d'hologrammes visuels, pouvant être obtenus par un procédé selon la revendication 6.

8. Utilisation de supports selon la revendication 7 en tant qu'éléments optiques, écrans ou pour la présentation ou la projection d'images.

9. Procédé d'enregistrement d'un hologramme, selon lequel des supports selon la revendication 7 sont utilisés.

**Figur 1:**

**Figur 2:**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6743552 B
- US 6765061 B
- US 6780546 B
- US 20060194120 A
- JP 2007101743 B
- WO 03102959 A
- WO 03023520 A
- EP 0223587 A


**In der Beschreibung aufgeführte Nicht-Patentliteratur**

- Römpp Lexikon Chemie. Georg-Thieme-Verlag, 1998, 465-466
- **HOUBEN-WEYL.** Methoden der organischen Chemie. Georg Thieme Verlag, 1961, vol. XIV/1, 433ff
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- **H. KOGELNIK.** *The Bell System Technical Journal,* November 1969, vol. 48 (9), 2909, , 2947